# FASCICULE DE BREVET EUROPEEN

(11) **EP 1 864 743 B1**
(45) Date de publication et mention de la délivrance du brevet: **08.04.2009**
(21) Numéro de dépôt: 07301051.4
(22) Date de dépôt: 21.05.2007
(51) Int. Cl.: B23K 1/00, G02B 6/42, H01L 21/60, H01S 5/022

(54) **Assemblage et procédé d'assemblage par brasage d'un objet et d'un support**
Verbindung und Verfahren zur Verbindung eines Gegenstands und eines Trägers durch Löten
Assembly and method of assembly by brazing of an object and a support

(30) Priorité: 06.06.2006 FR 0604984
(43) Date de publication de la demande: 12.12.2007
(73) Titulaire: COMMISSARIAT A L'ENERGIE ATOMIQUE, 75015 Paris (FR)
(72) Inventeur: Kopp, Christophe, 38120 Fontanil-Cornillon (FR); Baleras, François, 38170 Seyssinet (FR); Martinez, Christophe, 38100 Grenoble (FR)
(74) Mandataire: Vuillermoz, Bruno

(56) Documents cités:
- US-A- 5 897 335
- US-A1- 2002 153 092
- US-A1- 2003 098 511
- US-A1- 2003 111 727
- US-B1- 6 647 036

## Description

La présente invention concerne l'assemblage d'un objet, tel qu'un composant optoélectronique miniaturisé, sur un support, tel qu'une plateforme, par l'intermédiaire de billes de brasure. Dans l'assemblage objet de la présente invention, l'objet est positionné avec une grande précision par rapport au support.

Par ailleurs, la présente invention se rapporte également à un procédé d'assemblage d'un objet et d'un support par l'intermédiaire d'un matériau de brasure.

### ETAT ANTERIEUR DE LA TECHNIQUE

Dans le domaine des dispositifs miniaturisés, il est indispensable de positionner les composants miniaturisés de façon d'autant plus précise que l'échelle de miniaturisation est petite. Ainsi, une grande précision peut être requise pour positionner un composant par rapport à un autre composant, mais également un composant par rapport à son support. En effet, si les dimensions du support présentent de faibles défauts géométriques, celui-ci peut servir de référence pour assurer un positionnement précis des composants les uns par rapport aux autres.

Cela est particulièrement vrai des composants qui doivent remplir une fonction optique ou une fonction mécanique. En effet, dans ces deux cas, l'alignement des composants émetteur et récepteur d'un faisceau optique ou celui d'un micro actionneur mécanique et de son capteur revêt une importance capitale pour le fonctionnement de l'ensemble du dispositif.

La tendance actuelle vers une miniaturisation croissante de tels circuits et de tels composants rend toujours plus difficile la réalisation d'assemblages de tels objets sur leur support, d'une part, en raison des dimensions réduites des surfaces d'assemblage et, d'autre part, en raison de la nécessité d'une précision accrue.

Parmi les composants miniaturisés nécessitant un positionnement précis, on trouve les composants optiques, les composants optoélectroniques ainsi que les composants mécaniques, magnétiques, ou électromécaniques tels que les puces MEMS (de l'anglais *Micro Electro Mechanical System).* Les composants de ces différentes catégories peuvent remplir des fonctions très diverses.

Les composants optiques sont généralement « passifs », c'est-à-dire qu'ils ne nécessitent pas d'alimentation électrique pour traiter la lumière qu'ils reçoivent. Comme exemples de composants optiques, on peut citer les composants exerçant une fonction de guidage de la lumière tel qu'un miroir, une fibre optique ou une lentille, ou encore des composants exerçant une fonction de filtrage spectral (cavité résonante) ou spatial (isolateur, filtre dans le plan de Fourier). Par ailleurs, certains composants optiques peuvent être « actifs », par exemple pour remplir une fonction d'amplification optique comme dans le cas d'une puce à micro-laser solide pompé optiquement.

Les composants optoélectroniques, quant à eux, sont généralement actifs, c'est-à-dire qu'ils possèdent une interface électronique et nécessitent une alimentation électrique afin de traiter la lumière reçue et/ou émise. Parmi les composants optoélectroniques nécessitant un positionnement précis, on trouve les émetteurs de lumière tel qu'un émetteur à micro laser solide pompé par diodes laser ou un émetteur laser à cavité verticale émettant par la surface (abrégé en VCSEL d'après l'anglais *Vertical Cavity Semi Conducteur Emitting Laser),* ou encore des polarisateurs dont la fonction est par définition de modifier la polarisation de la lumière qui les traverse.

Parmi les composants miniaturisés à fonction mécanique, on trouve les actionneurs et les capteurs présentant une pièce mobile, dont la fonction est de transmettre ou de détecter des contraintes ou des mouvements. C'est ainsi le cas de capteurs inertiels tels que les accéléromètres, les gyroscopes et autres magnétomètres. C'est également le cas de dispositif effectuant une mesure uni-axiale, que l'on peut assembler de manière à former un système de mesure triaxial.

On conçoit aisément que la plupart des composants miniatures à fonction optique, optoélectronique et/ou mécanique nécessitent un positionnement précis par rapport à leur support ou par rapport aux autres composants avec lesquels ils interagissent et forment un ensemble cohérent. En particulier, dans le cas des faisceaux de laser, il est très souvent nécessaire d'aligner précisément les émetteurs, les récepteurs et les composants intermédiaires les uns par rapport aux autres, de manière à transmettre le plus d'informations et/ou de puissance possible.

Une première solution de l'art antérieur consiste à réaliser l'assemblage d'un objet, le plus souvent un composant miniaturisé, et d'un support généralement de forme plate, au moyen de la technique bien connue sous l'expression anglo-saxonne *«flip chip* ». Cette technique largement répandue est utilisée pour effectuer les connexions électriques de composants électroniques miniaturisés, notamment de composants microélectroniques.

Cette technologie peut mettre en oeuvre un brasage par l'intermédiaire de billes de brasure positionnées entre la « puce » et son support. Au cours du procédé d'assemblage, le matériau de brasure fondu adopte la forme d'une bille, car il est mis en contact avec des zones de mouillabilité réalisées respectivement sur la puce et sur le support. Ces zones de mouillabilité sont en effet définies de manière à favoriser la formation de billes de brasure par le phénomène bien connu de la tension superficielle.

Comme les zones de mouillabilité sont réalisées sur la face active de la puce au cours de sa fabrication, cette face active fait face à la plateforme faisant office de support. Inversement, lorsque les connexions électriques du composant sont réalisées au moyen d'un câblage par fil, la face active de la puce se trouve généralement tournée vers l'extérieur, c'est-à-dire dans la direction opposée au support.

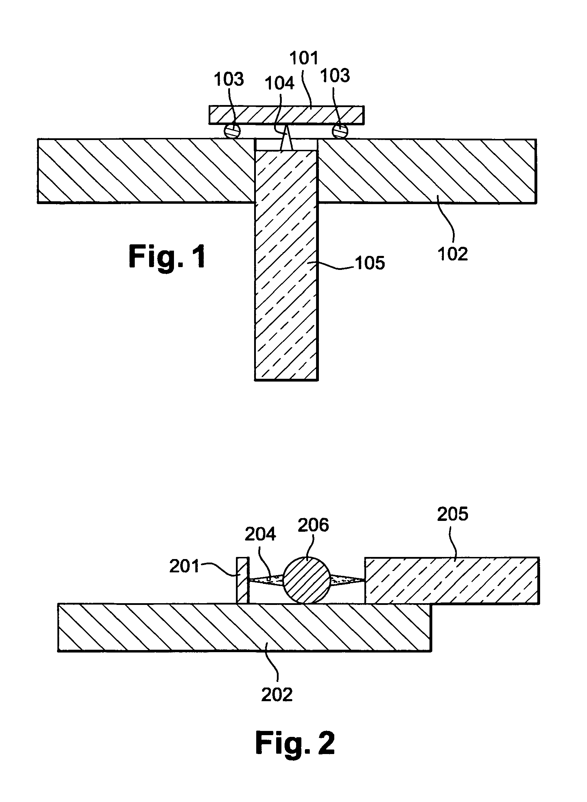

L'assemblage illustré par la figure 1 présente un émetteur laser à cavité verticale émettant par la surface (VCSEL) **101** avec une plateforme **102** percée de manière à loger une fibre optique **105**, comme dans le cas du document US-A-2003/0 098 511. La fibre optique **105** est destinée à guider de manière connue un faisceau laser **104** émis par l'émetteur **101**. L'émetteur **101** est assemblé avec la plateforme **102** au moyen de billes de brasure **103** selon une des techniques *« Flip Chip* ». Selon cette technique, chacune des billes **103** est formée par refusion du matériau de brasure entre l'émetteur laser **101** et la plateforme **102**.

Plus précisément, chacune des billes **103** est formée en contact avec deux zones de mouillabilité (non représentées), de nature généralement métallique, disposées respectivement sur l'objet **101** et sur le support **102**. Ces zones de mouillabilité sont dimensionnées et positionnées de manière à permettre l'alignement de l'objet 101 avec le support **102** par le phénomène de la tension superficielle. Cet alignement, un parallélisme dans l'exemple de la figure 1, est rendu possible par le fait que les billes 103 sont constituées d'une quantité identique de matériau de brasure.

Ainsi, lors de la mise en oeuvre du procédé d'assemblage selon une des techniques *« flip chip* », les billes de brasure **103** permettent en quelque sorte un « auto-alignement » de l'émetteur **101** par rapport à la plateforme **102.** En fait, cet alignement est réalisé par l'effet des forces de tension superficielle, qui s'exercent de manière à réaliser un équilibre dans lequel l'énergie de surface à l'interface entre la bille de brasure et sa zone de mouillabilité est minimale. De manière connue, dans un tel équilibre, la position et la forme de la bille de brasure **103** sont symétriques par rapport à sa zone de mouillabilité. Lorsque l'émetteur laser **101** est aligné de la sorte sur le support, la totalité du faisceau laser **104** qu'il émet est transmise à la fibre optique **105**, à la condition que cette dernière soit aussi correctement positionnée sur le support.

Cependant, un tel procédé d'assemblage présente des inconvénients. Ainsi, il nécessite le perçage de la plateforme **102** et l'insertion de la fibre optique **105** dans le logement percé. Or, ces opérations s'avèrent d'autant plus délicates que les composants à manipuler sont petits. Ainsi, dans le cas de composants miniaturisés, par exemple de dimensions micrométriques, ces opérations sont particulièrement difficiles à réaliser, et la précision résultante peut s'avérer médiocre.

Alternativement, pour éviter de percer la plate-forme, il est possible de placer l'émetteur laser dans l'autre sens de manière à émettre le faisceau vers l'extérieur, c'est-à-dire dans la direction opposée à la plateforme.

Toutefois, il est alors nécessaire d'implanter un miroir de renvoi à 90° de manière à orienter le faisceau laser vers les autres composants disposés à la surface de la plateforme, tel qu'une fibre optique. Or, une telle implantation est difficile et coûteuse à réaliser. Elle pose en effet également le problème de l'alignement des composants, induit un coût matériel supplémentaire, celui du miroir, et peut altérer les performances du faisceau laser.

Pour remédier à ces problèmes, une solution de l'art antérieur, illustrée par la figure 2, consiste à assembler l'émetteur laser à cavité verticale émettant par la surface (VCSEL) **201** perpendiculairement à une plateforme **202**. Ainsi, l'émetteur laser **201** émet un faisceau laser **204** selon une direction parallèle à la surface de la plateforme **202**. Le faisceau laser **204** peut ensuite être transmis par une lentille **206** à une fibre optique **205**.

Ainsi, le document US-B-6 647 036 décrit un émetteur laser VCSEL positionné sur une plateforme microélectronique avec un angle déterminé, en particulier à 90°. Selon ce procédé, l'objet est d'abord maintenu, au moyen d'une pompe à vide, fermement en contact avec le support avant d'y être solidarisé au moyen de billes de brasure refondues.

Cependant, le procédé décrit dans ce document présente plusieurs inconvénients. Tout d'abord, dans un tel procédé, il est également nécessaire de percer la plateforme pour pouvoir « aspirer » l'objet et le maintenir au contact de la plate-forme, ce qui engendre un coût supplémentaire de fabrication.

De plus, la précision obtenue par un tel assemblage est relativement précaire et s'avère insuffisante dans des applications où la miniaturisation des composants dépasse un certain seuil. Ainsi, d'après ce document, la précision de l'alignement du faisceau laser sur la plateforme ne serait que d'environ 2 à 3 micromètres pour des composants présentant des dimensions de l'ordre de quelques centaines de micromètres (US-B-6 647 036 : col. 3,1. 55-60).

Parmi les facteurs limitant la précision de l'opération d'alignement effectuée selon ce procédé, on trouve tout d'abord le contact requis entre l'objet et le support. Or, la surface de l'objet destiné à entrer en contact avec le support est le plus souvent issue d'une découpe et présente donc une géométrie irrégulière, qui est susceptible d'altérer l'alignement du faisceau laser.

En outre, si les zones de mouillabilité ou « tampons » disposés sur la plateforme sont trop ou trop peu écartés par rapport à l'épaisseur de l'objet, c'est-à-dire l'émetteur laser, il y a un risque de mauvais alignement de l'un par rapport à l'autre. De même, si ces « tampons » ne sont pas disposés convenablement sur l'objet, alors celui-ci risque d'être mal aligné par rapport au support.

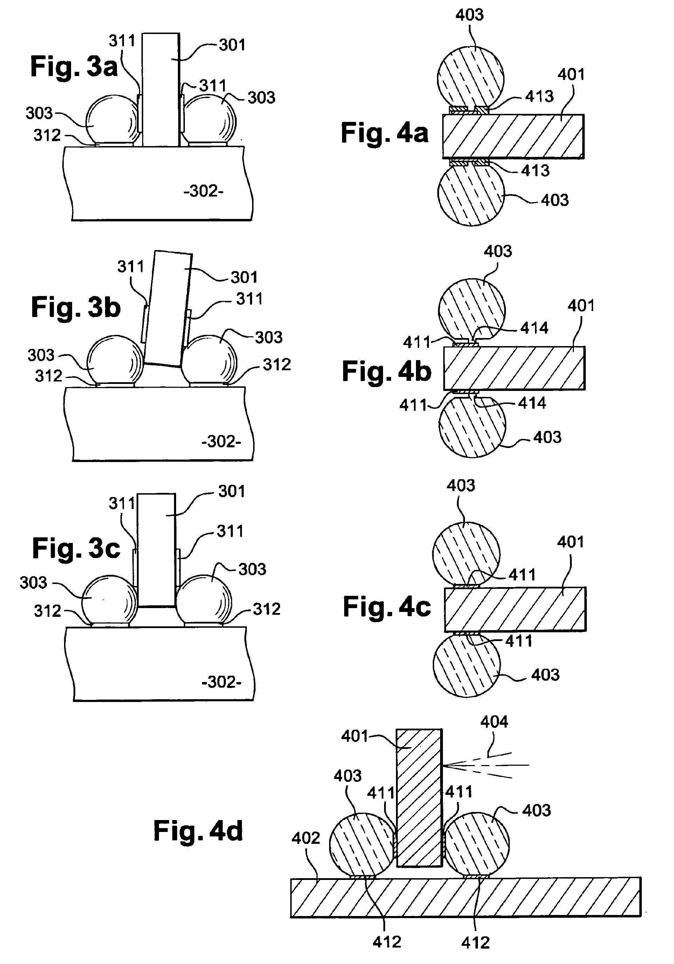

De tels défauts de positionnement sont illustrés par les figures 3a à 3c. Ainsi, dans l'assemblage de la figure 3a, les zones de mouillabilité **311** de l'objet **301** sont situées trop « haut », ce qui rend délicat la mise en contact de l'objet **301** et du support **302** ainsi que la réalisation d'un équilibre par les forces de tension superficielle. Dans les assemblages des figures 3b et 3c, les zones de mouillabilité **312** du support **302** ne sont pas assez écartées et risquent aussi, lors du positionnement de l'objet **301**, d'empêcher la réalisation d'un équilibre par les forces de tension superficielle.

Par conséquent, l'assemblage et le procédé d'assemblage décrits par le document US-B-6 647 036 ne permettent pas d'atteindre une précision satisfaisante dans le positionnement de l'objet par rapport le support et présentent en outre de nombreux risques de défaillance, c'est-à-dire d'alignement imparfait, voire de non alignement.

La présente invention a donc pour objet un assemblage et un procédé d'assemblage par brasage d'un objet et d'un support ne présentant pas les inconvénients de l'art antérieur, c'est-à-dire dont la réalisation ne soit pas excessivement délicate à mettre en oeuvre et dont la précision de positionnement ne dépende pas de facteurs trop nombreux ou difficiles à maîtriser.

### OBJET DE L'INVENTION

La présente invention se rapporte donc à un assemblage d'un objet et d'un support par brasage, de structure simple, d'une grande précision de positionnement et peu coûteuse relativement à cette grande précision.

L'objet de l'invention est donc un assemblage d'un objet et d'un support par l'intermédiaire de billes de brasure. Au moins deux zones de mouillabilité sont réalisées respectivement sur l'objet et sur le support, Chacune des billes de brasure assure un contact électrique et une fixation mécanique d'une part avec l'une des zones de mouillabilité de l'objet et d'autre part avec l'une des zones de mouillabilité du support. De plus, la température de fusion des billes de brasure est inférieure à la température de fusion de chacune des zones de mouillabilité. Selon l'invention, chaque zone de mouillabilité de l'objet forme un angle compris entre 70° et 110° avec chaque zone de mouillabilité du support. En outre, l'objet et le support sont mutuellement distants.

En d'autres termes, il y a un angle substantiel entre l'objet et le support et il n'y pas de contact entre l'objet et le support, l'assemblage de l'un et de l'autre se faisant exclusivement par l'intermédiaire de billes de brasure.

Selon une forme de réalisation pratique de l'invention, cet angle peut être sensiblement égal à 90°.

Un tel angle entre les zones de mouillabilité de l'objet et du support permet de présenter l'objet sensiblement perpendiculairement par rapport au support et, partant, de limiter les contraintes mécaniques qu'il exerce sur les billes de brasure. De plus, il permet de positionner de manière avantageuse certains composants, tels qu'un émetteur laser à cavité verticale émettant par la surface (VCSEL).

Selon une deuxième forme de réalisation de l'invention, la partie inférieure de l'objet peut être reçue dans une cavité réalisée dans le support, le bord inférieur de l'objet étant distant du fond de la cavité.

Autrement dit, la partie basse de l'objet peut être logée sans contact dans une cavité ménagée dans le support. Cela permet notamment, outre la précision du positionnement relatif, de limiter le dépassement de l'objet au-delà de la surface du support.

Selon une forme de réalisation de l'invention, les billes de brasure peuvent présenter différentes dimensions.

Une telle caractéristique permet de réaliser les billes de brasure remplissant différentes fonctions : de petites billes pour optimiser la précision du positionnement de l'objet par rapport au support et de grandes billes pour supporter convenablement l'objet sans contact avec le support. Cela permet aussi de former un angle déterminé entre chaque zone de mouillabilité de l'objet et chaque zone de mouillabilité du support.

En pratique, le matériau des billes de brasure peut être constitué d'un élément pur ou d'un alliage d'éléments choisis dans le groupe comprenant l'étain (Sn), le plomb (Pb), l'or (Au) et l'indium (In).

Un tel matériau présente une température de fusion relativement basse, donc facile et rapide à atteindre, ce qui permet, indirectement, un large choix pour les matériaux constituant les autres composants en présence.

Selon une forme de réalisation pratique de l'invention, chaque zone de mouillabilité peut comporter un empilement de plusieurs couches dont les matériaux sont constitués d'éléments sélectionnés dans le groupe comprenant le titane (Ti), le nickel (Ni) et l'or (Au).

De tels matériaux peuvent s'avérer suffisamment mouillants pour les billes de brasure.

En pratique, le support peut être une plate-forme microélectronique et l'objet peut être un composant optique ou optoélectronique, tel qu'un émetteur laser à cavité verticale émettant par la surface (VCSEL).

Un tel assemblage permet d'émettre un faisceau laser de façon précise dans un plan parallèle au plan formé par la plateforme microélectronique.

Par ailleurs, la présente invention concerne un procédé d'assemblage par brasage d'un objet et d'un support de réalisation relativement simple, bon marché et conduisant à une grande précision du positionnement relatif entre l'objet et le support.

Le procédé d'assemblage d'un objet et d'un support se fait par l'intermédiaire d'un matériau de brasure, au moins deux zones de mouillabilité étant réalisées respectivement sur l'objet et sur le support. De plus, la température de fusion du matériau de brasure est inférieure à la température de fusion de chacune des zones de mouillabilité. Selon l'invention, le procédé d'assemblage consiste :
- à former des billes de brasure sur le support ou sur l'objet au moyen d'une succession d'étapes consistant :
   ■ à réaliser, soit sur chaque zone de mouillabilité de l'objet, soit sur chaque zone de mouillabilité du support, une galette constituée du matériau de brasure ;
   ■ à chauffer les galettes au-delà de la température de fusion du matériau de brasure mais en deçà de la température de fusion de chacune des zones de mouillabilité, de manière à transformer par tension superficielle chacune des galettes en une bille de brasure ;
   ■ à refroidir l'assemblage obtenu jusqu'à une température inférieure à la température de fusion du matériau de brasure, de façon à figer les billes de brasure ainsi formées ;
- à positionner l'objet par rapport au support de manière à placer chacune des billes de brasure sensiblement et partiellement en regard de la surface de chaque zone de mouillabilité de l'objet d'une part, et d'une surface correspondante de chaque zone de mouillabilité du support d'autre part, chaque zone de mouillabilité de l'objet formant un angle compris entre 70° et 110° avec chaque zone de mouillabilité du support ;
- à chauffer les galettes au-delà de la température de fusion du matériau de brasure, de façon à former et à mouvoir les billes de brasure par tension superficielle, de manière à assurer une coopération entre chaque bille de brasure et l'une des zones de mouillabilité de l'objet d'une part, et l'une des zones de mouillabilité du support d'autre part ;
- à refroidir l'assemblage obtenu jusqu'à une température inférieure à la température de fusion du matériau de brasure, de façon à figer l'assemblage ainsi formé.

En d'autres termes, les contacts mécaniques et électriques ne surviennent qu'entre les billes de brasure et les zones de mouillabilité de l'objet d'une part, et entre les billes de brasure et les zones de mouillabilité du support d'autre part. Ainsi, il n'y a pas de contact entre l'objet et le support. Par conséquent, l'assemblage du premier par rapport au deuxième résultant d'un tel procédé est susceptible de présenter une grande précision de positionnement.

Selon un premier mode de réalisation du procédé objet de l'invention, l'étape de formation des billes de brasure peut comprendre la succession d'étapes consistant :
- à déposer sur les zones de mouillabilité de l'objet un revêtement sacrificiel peu mouillant vis-à-vis du matériau de brasure et présentant une température de fusion supérieure à celle du matériau de brasure, le revêtement sacrificiel s'étendant de manière dissymétrique sur la surface principale de chaque zone de mouillabilité de l'objet ;
- à percer dans ledit revêtement sacrificiel des orifices débouchant chacun au niveau de la surface principale d'une zone de mouillabilité de l'objet et vers la partie de la zone de mouillabilité de l'objet opposée au bord le plus proche de l'objet ;
- à réaliser les galettes par dépôt du matériau de brasure sur le revêtement sacrificiel y compris dans l'orifice ;
- à chauffer les galettes au-delà de la température de fusion du matériau de brasure, de manière à les transformer par tension superficielle en billes de brasure recouvrant totalement ou partiellement le revêtement sacrificiel ;
- à ôter le revêtement sacrificiel, chaque bille étant alors reliée à une zone de mouillabilité par un pied issu du dépôt du matériau de brasure dans ledit orifice, le pied étant positionné sur la partie de la zone de mouillabilité opposée au bord le plus proche de l'objet ;
- à découper le bord de l'objet le plus proche de la zone de mouillabilité de manière à réduire l'une des dimensions de l'objet ;
- à chauffer les billes de brasure au-delà de leur température de fusion, de manière à recouvrir totalement chacune des zones de mouillabilité, la périphérie des billes de brasure dépassant du bord de l'objet issu de ladite découpe, les billes recouvrant les zones de mouillabilité du support par l'effet de la tension superficielle.

Cette méthode permet donc de former les billes de brasure sur les zones de mouillabilité de l'objet, puis de les solidariser aux zones de mouillabilité du support. Cette méthode utilisant un revêtement sacrificiel pour positionner chaque bille de brasure préalablement à sa solidarisation aux zones de mouillabilité de l'objet et du support permet d'éviter un écartement trop faible ou trop important des billes de brasure lors de l'étape finale d'assemblage de l'objet et du support.

Selon un deuxième mode de réalisation du procédé objet de l'invention, l'étape de formation des billes de brasure peut comprendre la succession d'étapes consistant :
- à déposer sur les zones de mouillabilité du support un revêtement sacrificiel peu mouillant vis-à-vis du matériau de brasure et présentant une température de fusion supérieure à celle du matériau de brasure, le revêtement sacrificiel s'étendant de manière dissymétrique sur la surface principale de chacune des zones de mouillabilité du support ;
- à percer dans le revêtement sacrificiel des orifices débouchant chacun au niveau de la surface principale d'une zone de mouillabilité du support et de manière décalée vers le côté opposé à l'autre zone de mouillabilité du support ;
- à réaliser les galettes par dépôt du matériau de brasure sur le revêtement sacrificiel y compris dans les orifices ;
- à chauffer les galettes au-delà de la température de fusion du matériau de brasure, de manière à les transformer par tension superficielle en billes de brasure recouvrant totalement ou partiellement le revêtement sacrificiel ;
- à ôter le revêtement sacrificiel, chaque bille étant alors reliée à une zone de mouillabilité par un pied issu du par un pied issu du dépôt du matériau de brasure dans l'orifice, le pied étant positionné sur la zone de mouillabilité du côté opposé à l'autre zone de mouillabilité du support.

Cette méthode permet donc de former les billes de brasure sur les zones de mouillabilité du support, puis de les solidariser aux zones de mouillabilité de l'objet. Cette méthode utilisant un revêtement sacrificiel pour positionner chaque bille de brasure préalablement à sa solidarisation aux zones de mouillabilité de l'objet et du support permet d'éviter un écartement trop faible ou trop important des billes de brasure lors de l'étape finale d'assemblage de l'objet et du support.

Selon une forme de réalisation pratique de l'invention, le support peut présenter, entre ses deux zones de mouillabilité, au moins une zone de mouillabilité supplémentaire, de dimensions inférieures à celles de chacune des deux zones de mouillabilité, la zone de mouillabilité supplémentaire étant soumise à l'étape de formation de bille de brasure identique à celle décrite ci-avant, avec ou sans décalage de l'orifice afférent. De plus, l'étape de positionnement de l'objet peut comprendre la succession d'étapes consistant :
- à positionner l'objet entre les deux grandes billes en contact avec la petite bille ;
- à chauffer les billes de brasure au-delà de la température de fusion du matériau de brasure, de manière à recouvrir par tension superficielle substantiellement chaque zone de mouillabilité de l'objet et du support.

Selon un autre mode de réalisation de l'invention, le procédé comprend en outre une étape consistant à réaliser dans le support une cavité destinée à recevoir la partie inférieure de l'objet et en ce que l'étape de positionnement de l'objet peut comprendre la succession d'étapes consistant :
- à positionner la partie inférieure de l'objet dans la cavité de manière à ce que les zones de mouillabilité de l'objet se trouvent à une altitude supérieure à l'altitude du centre de gravité de l'objet et supérieure à l'altitude de la surface supérieure du support ;
- à chauffer les billes de brasure au-delà de la température de fusion du matériau de brasure, de manière à recouvrir par tension superficielle substantiellement chaque zone de mouillabilité du support et de l'objet, lequel est ainsi susceptible de s'aligner verticalement sous l'effet d'une part de la gravité et d'autre part des forces de tension superficielle générés par les billes de brasure en fusion sur les zones de mouillabilité de l'objet.

Autrement dit, ce procédé consiste à utiliser le poids de l'objet pour l'aligner verticalement, tel un fil à plomb, les forces de tension superficielle exercées par les billes de brasure sur les zones de mouillabilité de l'objet constituant des forces de rappel maintenant l'objet en position stable.

### BREVE DESCRIPTION DES FIGURES

La manière dont l'invention peut être réalisée et les avantages qui en découlent ressortiront des exemples de réalisation qui suivent, donnés à titre indicatif et non limitatif à l'appui des figures annexées.
La figure 1 est une représentation schématique de l'assemblage d'un composant optoélectronique miniaturisé, en l'occurrence un émetteur laser VCSEL, avec une plate-forme microélectronique, assemblage réalisé par une des techniques « *flip chip* ». La figure 1 a déjà été décrite en relation avec l'art antérieur.
La figure 2 est une représentation schématique de l'assemblage d'un composant optoélectronique miniaturisé, en l'occurrence un émetteur laser VCSEL, avec une plate-forme microélectronique, assemblage réalisé au moyen d'une des techniques *« flip chip* ». La figure 2 a déjà été décrite en relation avec l'art antérieur.
Les figures 3a à 3c sont des représentations schématiques illustrant les inconvénients des procédés d'assemblage de l'art antérieur. Les figures 3a à 3c ont déjà été décrites en relation avec l'art antérieur.
Les figures 4a à 4d sont des représentations schématiques vues de côté illustrant certaines étapes d'un premier mode de réalisation du procédé d'assemblage objet de la présente invention. La figure 4d représentant l'étape finale de ce procédé est donc également une représentation schématique d'un premier mode de réalisation de l'assemblage objet de l'invention.
Les figures 5a à 5d sont des représentations schématiques vues de côté illustrant certaines étapes d'un deuxième mode de réalisation du procédé d'assemblage objet de la présente invention. La figure 5d représentant l'étape finale de ce procédé est donc également une représentation schématique d'un deuxième mode de réalisation de l'assemblage objet de l'invention.
La figure 6 est une représentation schématique vue de face de l'assemblage illustré par la figure 5d.
Les figures 7a et 7b sont des représentations schématiques vue de côté et vue de face d'une troisième forme de réalisation de l'assemblage objet de l'invention.
La figure 8 est une représentation schématique vue de côté d'une quatrième forme de réalisation de l'assemblage objet de l'invention.
La figure 9 est une représentation schématique vue de côté d'une cinquième forme de réalisation de l'assemblage objet de la présente invention.
Les figures 10a et 10b sont des représentations schématiques en perspective illustrant deux étapes d'une autre forme de réalisation du procédé d'assemblage objet de la présente invention. La figure 10b représentant l'étape finale de ce procédé est donc une représentation schématique d'une sixième forme de réalisation de l'assemblage objet de l'invention.

### MODES DE REALISATION DE L'INVENTION

La figure 4d illustre une première forme de réalisation de l'assemblage de l'invention. L'objet **401** est un émetteur laser à cavité verticale émettant par la surface (VCSEL) susceptible d'émettre un faisceau laser **404**.

L'objet **401** est assemblé avec un support **402** par l'intermédiaire de plusieurs billes de brasure **403**. Pour solidariser les billes de brasure **403** sur l'objet **401**, ce dernier présente une zone de mouillabilité **411** pour chaque bille de brasure **403**. De même, pour solidariser les billes de brasure **403** sur le support **402**, en l'occurrence une plateforme microélectronique, le support **402** présente une zone de mouillabilité **412** pour chaque bille de brasure **403**. Compte tenu de la mouillabilité de ces zones, chaque bille de brasure **403** recouvre substantiellement les zones de mouillabilité **411** et **412**, avec lesquelles elle entre en contact lorsqu'elle est à l'état de matériau de brasure refondu.

Dans l'exemple de la figure 4d, les zones de mouillabilité **411** et **412** sont constituées par des empilements de couches de métaux superposées, dont la température de fusion est supérieure à la température de fusion du matériau constituant les billes de brasure **403**. Cette propriété permet de ne pas altérer les zones de mouillabilité **411** et **412** lors de l'étape de formation des billes de brasure **403** au cours de laquelle le matériau de brasure est chauffé au-delà de sa température de fusion, comme cela est exposé en détail par la suite.

En l'occurrence, les billes de brasure **403** sont constituées d'un alliage fusible à 60 % d'étain (Sn) et à 40 % de plomb (Pb), tandis que les zones de mouillabilité **411** et **412** sont constituées par des empilements de couches minces de métaux, tel que le titane (Ti), le nickel (Ni) et l'or (Au).

De tels matériaux sont en effet susceptibles de coopérer de manière à former des billes **403** recouvrant substantiellement, voire complètement chaque zone de mouillabilité **411** et **412**. Pour un tel recouvrement, de manière connue, il faut que l'énergie d'interface entre le matériau constitutif d'une bille de brasure **403** et la matière constituant la zone de mouillabilité **411** ou **412** soit suffisamment faible pour que le liquide s'étale sur la surface de la zone de mouillabilité **411** ou **412**.

Pour optimiser la mouillabilité des zones **411** et **412**, on peut prévoir, comme dans le cas de la figure 4d, de réaliser des zones présentant une surface principale sensiblement plane et en forme de disque. Néanmoins, il est possible de sélectionner, en tant que de besoin, d'autres formes des zones de mouillabilité, sans pour autant sortir du cadre de cette invention.

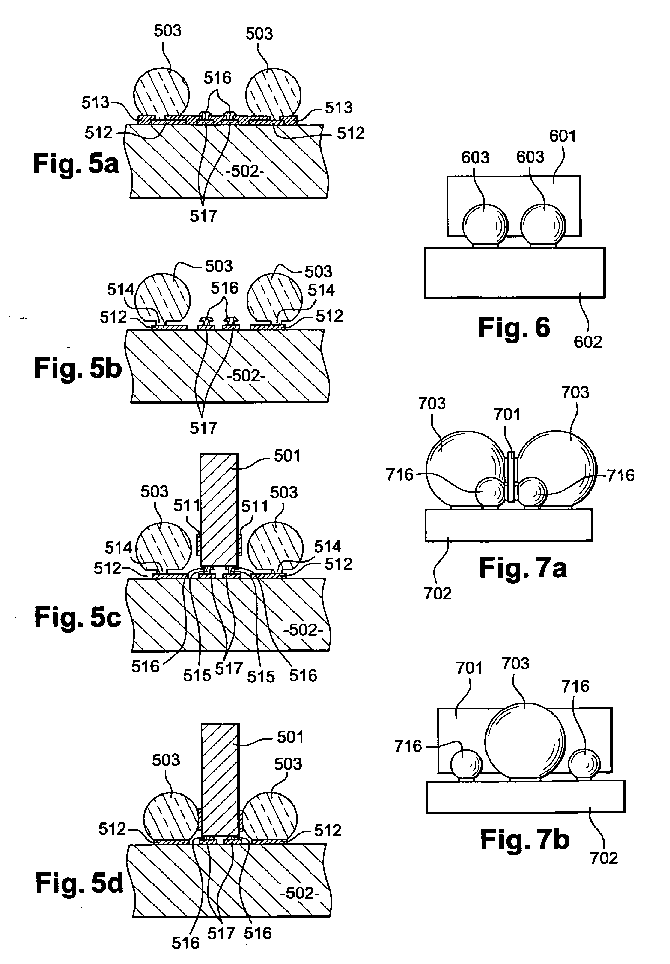

Par ailleurs, pour fabriquer les billes de brasure, on commence par réaliser des galettes sur l'objet (figures 4a à 4d) ou sur le support (figures 5a à 5d). La méthode de fabrication des galettes et celle des zones de mouillabilité sont exposées ci-après de manière relativement générale, dans la mesure où elles sont réalisées conformément aux procédés existant dans l'art antérieur.

De manière connue, lorsque le matériau de brasure se trouve à l'état liquide, il tend à former une goutte ou une bille partout où il est en contact avec l'air environnant. En effet, le système constitué par le matériau de brasure liquide et l'air qui l'entoure, tend à minimiser l'énergie de surface, ce qui le conduit à former une sphère de façon à minimiser le rapport de la surface sur le volume de matière.

Il est à noter que l'emploi du terme bille, désignant usuellement une forme sphérique, pour désigner le matériau de brasure **403**, est quelque peu abusif, car, d'une part, cette forme est tronquée par les zones de mouillabilité et, d'autre part, ces zones de mouillabilité, en fonction de leur position relative, peuvent exercer des efforts de faible intensité sur le matériau de brasure, déformant ainsi la bille en une ellipsoïde, voire en une forme plus complexe. Cet abus de langage a néanmoins été consacré par la pratique dans différents domaines techniques, si bien que le terme de bille est employé dans cet exposé pour désigner la forme adoptée par le matériau de brasure au contact de l'air et des zones de mouillabilité. Dans tous les cas, la forme des billes de brasure dépend de la quantité de matière fusible mise en jeu, des dimensions et des positions des zones de mouillabilité de l'objet et du support.

Compte tenu de la nature conductrice du matériau constituant les billes de brasure **403**, celles-ci assurent en outre un contact électrique entre les zones de mouillabilité **411** et **412** et, partant, entre un circuit du support **402** et un circuit de l'objet **401**. Un tel contact électrique permet donc de faire circuler un courant électrique entre lesdits circuits de manière à alimenter l'objet **401**, lorsqu'il s'agit d'un composant « actif » tel que l'émetteur laser VCSEL **401**.

Outre le contact électrique, chacune des billes de brasure **403**, après refroidissement, remplit la fonction de fixation mécanique par soudure entre la zone de mouillabilité **411** et la zone de mouillabilité **412**, c'est-à-dire indirectement entre l'émetteur laser VCSEL **401** et la plateforme **402**. Typiquement, la température de refroidissement peut être la température ambiante.

Conformément à une caractéristique de l'invention, chaque zone de mouillabilité **411** de l'objet **401** forme un angle compris entre 70° et 110° avec chaque zone de mouillabilité **412** du support **402**. Dans l'exemple de la figure 4d, cet angle est de 90°, c'est-à-dire que les zones de mouillabilité **411** sont perpendiculaires aux zones de mouillabilité **412**.

Ici encore, un abus de langage est employé pour alléger l'exposé et en faciliter la compréhension. En effet, l'angle compris entre 70° et 110°, ici de 90°, est en fait formé entre deux droites définissant respectivement la dimension principale des zones de mouillabilité **411**, ici un axe vertical, et la dimension principale des zones de mouillabilité **412**, ici un axe horizontal. Par conséquent, cet objet **401** est perpendiculaire au support **402**, dans la mesure où la direction de la dimension principale des zones de mouillabilité **411** est parallèle à la direction de la dimension principale de l'émetteur laser VCSEL **401** et/ou la direction de la dimension principale des zones de mouillabilité **412** est parallèle à la direction principale de la plateforme microélectronique **402**.

De plus, dans le cas de la figure 4d, comme l'objet **401** présente deux faces planes parallèles sur lesquelles sont respectivement réalisées chacune des zones de mouillabilité **411** et comme les zones de mouillabilité **412** sont réalisées sur un même plan du support **402,** chaque zone de mouillabilité **411** de l'objet **401** forme un angle droit avec chaque zone de mouillabilité **412** du support **402**.

Néanmoins, sans sortir du cadre de l'invention, l'objet **401** ou le support **402** pourrait présenter des surfaces moins régulières, non parallèles ou non planes, si bien que chaque zone de mouillabilité de l'objet formerait alors un angle quelconque, compris entre 70° et 110°, avec chaque zone de mouillabilité du support. Dans un tel cas, l'angle formé entre une zone de mouillabilité de l'objet et une zone de mouillabilité du support, serait généralement différent des angles formés entre les autres zones de mouillabilité de l'objet et les autres zones de mouillabilité du support.

Par ailleurs, conformément à une caractéristique de l'invention, l'objet **401** et le support **402** sont mutuellement distants. Autrement dit, comme on peut le voir sur la figure 4d, l'objet **401** et le support **402** n'entrent pas en contact l'un avec l'autre. Cette caractéristique permet d'éviter un mauvais alignement de l'objet **401** sur le support **402**, en particulier dans les cas où la tranche inférieure de l'objet **401** présente des irrégularités suite à sa découpe.

Par conséquent, cette caractéristique permet de positionner l'objet par rapport au support avec une précision supérieure à celle des assemblages de l'art antérieur. Un assemblage conforme à la présente invention est ainsi susceptible de présenter une précision de positionnement submicronique, tandis que les assemblages de l'art antérieur ne permettent de réaliser que des positionnements avec une précision de l'ordre de quelques microns, comme dans le cas du document US-B-6 647 036. De plus, cette précision est obtenue de manière relativement simple et peu coûteuse, puisque le positionnement de l'objet par rapport au support est exclusivement réalisé par tension superficielle.

Ainsi, lorsque l'objet **401** est constitué par un émetteur laser VCSEL, celui-ci émet un faisceau laser **404** légèrement conique par nature, mais dont l'axe de symétrie est parfaitement parallèle au plan de la plateforme **402**. Une telle précision permet donc de transmettre le maximum de puissance et/ou d'information du laser vers d'autres composants, tels qu'une fibre optique. Le faisceau laser **404** peut ensuite être traité à l'instar du faisceau laser **204** illustré sur la figure 2.

Comme indiqué précédemment, la figure 4d représente l'étape finale d'une forme de réalisation du procédé d'assemblage objet de la présente invention. Au cours de cette dernière étape, on refroidit l'assemblage **401-403** jusqu'à une température inférieure à la température de fusion du matériau de brasure.

Auparavant, conformément au procédé objet de l'invention, il faut réaliser les étapes illustrées par les figures 4a à 4c et consistant, comme le montre la figure 4c, à former des billes de brasure **403** sur ledit support **402** ou sur ledit objet **401** au moyen de la séquence d'étapes détaillée ci-après.

Tout d'abord, il convient de positionner l'objet **401** à une distance déterminée du support **402** de manière à placer sensiblement et partiellement en regard chaque bille de brasure **403** avec la surface de chaque zone de mouillabilité **411** de l'objet **401** d'une part et avec une surface correspondante de chaque zone de mouillabilité **412** du support **402** d'autre part.

Puis, il faut chauffer les galettes au-delà de la température de fusion du matériau de brasure, de façon à déplacer les billes de brasure **403** par tension superficielle, de manière à assurer une coopération entre chaque bille de brasure **403** et l'une des zones de mouillabilité **411** de l'objet **401** d'une part et l'une des zones de mouillabilité **412** du support **402** d'autre part.

Plus précisément et selon l'invention, l'étape de formation des billes de brasure **403** sur l'objet **401** comprend la séquence d'étapes consistant d'abord à déposer sur les zones de mouillabilité **411** de l'objet **401** un revêtement sacrificiel **413.** Ce revêtement sacrificiel **413** est peu mouillant vis-à-vis du matériau de brasure et présente une température de fusion supérieure à celle du matériau de brasure. De plus, le revêtement sacrificiel **413** s'étend de manière dissymétrique sur la surface principale de chaque zone de mouillabilité de l'objet **401**.

Puis, il convient de percer dans le revêtement sacrificiel **413** des orifices débouchant chacun au niveau de la surface d'une zone de mouillabilité **411** de l'objet **401** et vers la partie de la zone de mouillabilité **411** de l'objet **401** opposée au bord le plus proche de l'objet **401**. Ainsi, chaque orifice est excentré par rapport à la surface de la zone de mouillabilité de l'objet qu'il dégage et les billes formées ne dépassent pas du bord de l'objet. On pourrait aussi prévoir de percer plusieurs orifices au niveau d'une même zone de mouillabilité.

Ensuite, il faut réaliser les galettes par dépôt du matériau de brasure sur le revêtement sacrificiel **413**, y compris dans ledit orifice, et chauffer les galettes au-delà de la température de fusion du matériau de brasure, de manière à les transformer par tension superficielle en billes de brasure **403** recouvrant totalement ou partiellement le revêtement sacrificiel **413**.

A la suite de cette étape, on ôte le revêtement sacrificiel **413**, par exemple au moyen d'une attaque chimique, ce qui fait que chaque bille est alors reliée à une zone de mouillabilité **411** par un pied **414** issu du dépôt du matériau de brasure dans l'orifice. Le pied est donc positionné sur la partie de la zone de mouillabilité opposée au bord le plus proche de l'objet. Le « champignon » formé par la bille et son pied est donc excentré par rapport à la surface principale de la zone de mouillabilité **411**.

Puis, il faut découper le bord de l'objet **401** le plus proche de la zone de mouillabilité **411** de manière à réduire l'une des dimensions de l'objet. Une telle découpe garantit l'absence de contact entre l'objet et le support dans l'assemblage résultant.

Enfin, on chauffe les billes de brasure **403** au-delà de leur température de fusion, de manière à recouvrir totalement chacune des zones de mouillabilité **411**, la périphérie des billes de brasure **403** dépassant du bord de l'objet **401** issu de la étape de découpe, les billes **403** recouvrant les zones de mouillabilité **401** du support **402** par l'effet de la tension superficielle.

Alternativement, mais de manière analogue, au premier mode de réalisation du procédé et de l'assemblage objet de l'invention illustrée par les figures 4a à 4d, il est possible de former les billes de brasure sur le support plutôt que sur l'objet, conformément à un deuxième mode de réalisation. Ainsi, dans l'exemple des figures 5a à 5d, les billes de brasure **503** sont formées sur un support **502**, puis solidarisées par brasage à un objet **501**, ici aussi un émetteur laser VCSEL. A l'instar de la forme de réalisation du procédé décrite en relation avec les figures 4a à 4d, on emploie un revêtement sacrificiel **513** s'étendant de manière dissymétrique sur chaque zone de mouillabilité **512**, **517** du support **502**.

A la différence de l'assemblage illustré par la figure 4d, l'assemblage illustré par la figure 5d présente deux sortes de billes de brasure **503** et **516** remplissant des fonctions différentes. Les billes de brasure **503** jouent un rôle analogue à celui des billes de brasure **403**, à savoir qu'elles assurent la connexion électrique et la solidarisation mécanique de la plateforme **502** avec l'émetteur laser VCSEL **501**. Leurs fonctions et leurs constitutions étant analogues à celles des billes **403**, elles ne seront pas détaillées ci-après.

Outre les billes **503**, l'assemblage de la figure 5d présente des billes de brasure 516 en contact avec la tranche inférieure de l'émetteur laser VCSEL **501**. Les billes **516** sont destinées à amortir le mouvement descendant de l'objet **501** lors de l'étape de refusion des billes **503** et jusqu'à ce que les billes **503** mouillent substantiellement et suffisamment les surfaces principales des zones de mouillabilité **512** du support **502** et **511** de l'objet **501,** de manière à supporter le poids de l'objet **501.**

Les billes **516** doivent pour cela être constituées d'un matériau de brasure présentant une température de fusion sensiblement égale à la température de fusion du matériau constituant les billes de brasure **503**. Dans l'exemple de la figure 5d, le matériau constituant les billes **516** est le même que le matériau constituant les billes **503**. Il s'agit d'un alliage fusible à 60% d'étain et 40 % de plomb, mais il pourrait également s'agir d'autres alliages ou de métaux purs comprenant de l'or, de l'étain, du plomb et/ou de l'indium.

Dans ce deuxième mode de réalisation de l'invention, l'étape de formation des grandes billes **503** sur les zones de mouillabilité **512** du support **502** est similaire à celle décrite en relation avec les figures 4a à 4c, à cette différence près que les billes de brasure **503** sont d'abord reliées au support **502** avant d'être liées à l'objet **501**. Par conséquent, l'étape de formation des billes **503** comprend la succession d'étapes illustrées par les figures 5a à 5c et consistant :
- à déposer sur les zones de mouillabilité **512** du support **502** un revêtement sacrificiel **513** peu mouillant vis-à-vis du matériau de brasure et présentant une température de fusion supérieure à celle du matériau de brasure, ledit revêtement sacrificiel **513** s'étendant de manière dissymétrique sur la surface principale de chacune des zones de mouillabilité du support **502** ;
- à percer dans le revêtement sacrificiel **513** des orifices débouchant chacun au niveau de la surface principale d'une zone de mouillabilité **512** du support **502** et de manière décalée vers le côté opposé à l'autre zone de mouillabilité **512** du support **502** ;
- à réaliser les galettes par dépôt du matériau de brasure sur le revêtement sacrificiel **513** y compris dans le orifice ;
- à chauffer les galettes au-delà de la température de fusion du matériau de brasure, de manière à les transformer par tension superficielle en billes de brasure **503** recouvrant totalement ou partiellement le revêtement sacrificiel **513** ;
- à ôter le revêtement sacrificiel **513**, par exemple au moyen d'une attaque chimique, chaque bille **503** étant alors reliée à une zone de mouillabilité **512** par un pied **514** issu du dépôt du matériau de brasure dans l'orifice, le pied **514** étant positionné sur la zone de mouillabilité **512** du côté opposé à l'autre zone de mouillabilité **512** du support **502**.

Il convient de noter ici que les petites billes de brasure **516** sont formées selon la même méthode de formation que les grandes billes de brasure **503**. Lorsque ces billes de brasure **516** sont dans l'état illustré par la figure 5b, c'est-à-dire une fois que les billes sont prédisposées à recevoir l'objet **501**, l'étape de positionnement de l'objet comprend la succession d'étapes consistant :
- à positionner l'objet **501** entre les deux grandes billes **503** en contact avec la petite bille **516** ;
- à chauffer les billes de brasure **503** et **516** au-delà de la température de fusion du matériau de brasure, de manière à recouvrir, substantiellement ou totalement, par tension superficielle chaque zone de mouillabilité **512** et **517** du support **502**, les billes recouvrant par ailleurs les zones de mouillabilité **511** de l'objet **501.**

A l'issue de cette étape de positionnement de l'objet **501** et après l'étape de refroidissement de l'assemblage caractéristique du procédé objet de l'invention, l'émetteur laser VCSEL **501** est assemblé à la plateforme microélectronique **502** par l'intermédiaire des billes de brasure **503**, lesquelles sont solidarisées aux zones de mouillabilité **511** et **512,** comme le montre la figure 5d.

Dans l'exemple de cette figure 5d, l'objet **501** se trouve alors en contact avec les petites billes **516**. Néanmoins selon l'emplacement choisi pour les zones de mouillabilité **511** sur l'objet **501,** et selon la quantité de matériau de brasure formant les billes **503** et **516**, on peut prévoir de maintenir l'objet **501** hors de contact des billes **516**. Le poids de l'objet **501** est alors supporté par les seules billes de brasure **503** par le phénomène de tension superficielle se manifestant à l'interface entre chacune des billes **503** et chaque zone de mouillabilité **511**. Ainsi, les petites billes de brasure 516 restent isolées de l'objet **501** après avoir supporté et amorti son mouvement descendant lors de l'étape de positionnement.

Comme l'objet **501** demeure à distance du support **502**, c'est-à-dire qu'il n'y a pas de contact entre eux, le positionnement ou l'alignement de l'objet **501** par rapport au support **502** peut être réalisé avec une précision supérieure à celle des assemblages de l'art antérieur.

En outre, compte tenu de l'écartement des billes de brasure 503 dans l'étape illustrée par la figure 5c, rendu possible par la mise en oeuvre du revêtement sacrificiel 513, il est relativement aisé de venir placer l'objet 501 entre les deux billes 503 avant l'étape de refusion, au cours de laquelle les billes de brasure 503 se rapprochent « naturellement » des zones de mouillabilité **511** de l'objet **501.** Ce rapprochement est du à la tension superficielle qui s'exerce à l'interface entre chacune des billes 503 et chaque zone de mouillabilité 512 du support 502. Ainsi, l'emploi du revêtement sacrificiel 513 permet d'atténuer voire d'éviter les problèmes liés à un mauvais dimensionnement ou à un mauvais positionnement des zones de mouillabilité, tels que ceux illustrés par les figures 3b et 3c.

Il faut noter ici qu'il n'est pas nécessaire d'excentrer les pieds des petites billes 516 sur les zones de mouillabilité 517. En effet, l'écartement des petites billes 516 n'a aucune incidence sur la possibilité d'insérer l'objet **501** entre les grandes billes **503.**

Pour assurer la stabilité de l'assemblage de l'objet 401 ou 501 sur le support 402 ou 502, il est préférable de prévoir de prendre l'objet « en étau » entre au moins deux couples de billes de brasure 403,503. Par couple de billes, on entend deux billes situées en regard l'une de l'autre et de part et d'autre de l'objet. Il est ainsi préférable de former au moins trois billes réparties sur deux faces opposées de l'objet pour assurer une certaine stabilité.

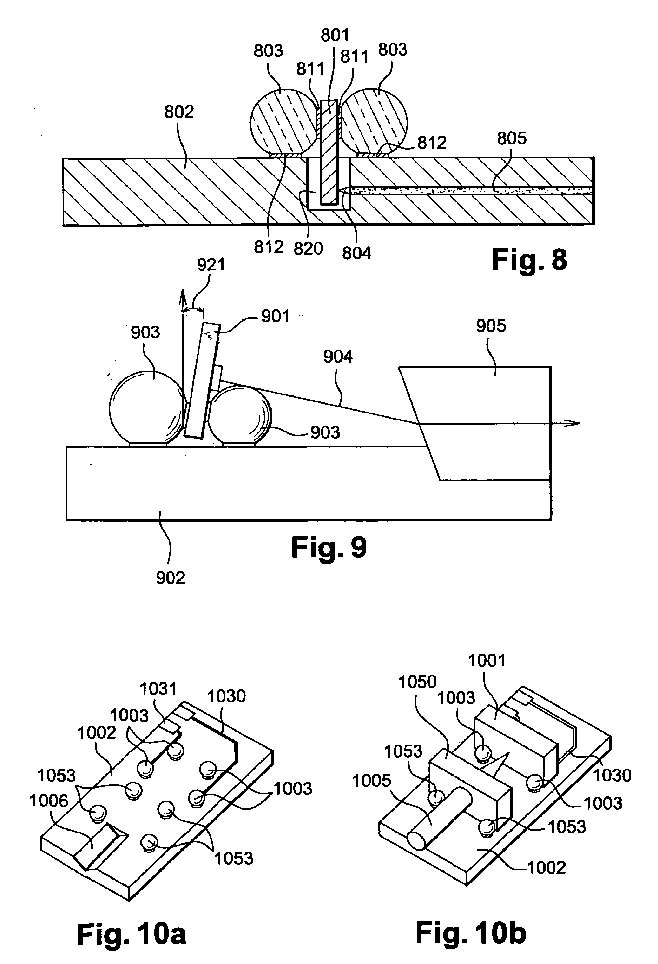

Ainsi, la figure 6 montre une vue de face des assemblages illustrés par les figures 4d et 5d, sur laquelle l'assemblage est réalisé par l'intermédiaire de deux couples de billes de brasure 603 installés côte à côte. Les billes de chacun 603 des couples étant situées en regard, de part et d'autre de l'objet 601. Cependant, en fonction des contraintes d'implantation ou autre, les billes de chacun des couples pourraient être quelque peu décalées, comme le montre la figure 10a.

Alternativement à la forme de réalisation illustrée par la figure 6 sur laquelle les billes de brasure 603 présentent les mêmes dimensions, on peut prévoir de réaliser des billes de brasure présentant différentes dimensions. Un tel assemblage est illustré par les figures 7a et 7b, respectivement en vue de côté et en vue de face. Dans cet assemblage, un objet 701 est assemblé avec un support 702 par l'intermédiaire de grandes billes de brasure 703 et de petites billes de brasure 716. Comme indiqué ci-dessus, les couples de billes de brasure 703, 716 sont installés côte à côte sur le support 702, de manière à maintenir l'objet 701 dans un état stable y compris lorsque les billes se trouvent à l'état refondu. Avec une telle structure, les grandes billes **703** supportent l'essentiel du poids de l'objet **701**, car elles présentent une grande interface avec celui-ci, tandis que les petites billes **716** permettent d'assurer la stabilité latérale et la précision du positionnement lors de la mise en oeuvre du procédé d'assemble objet de l'invention.

La figure 8 représente un autre mode de réalisation de l'assemblage de la présente invention. Dans cet assemblage, la partie inférieure de l'émetteur laser VCSEL **801** est reçue dans une cavité **820** réalisée dans la plateforme microélectronique **802**. Conformément à l'invention, des zones de mouillabilité **811** sont réalisées de part et d'autre de l'objet **801** et en des emplacements déterminés sur la surface du support **802**, de manière à accueillir des billes de brasure **803**.

Conformément à une caractéristique de l'invention, l'objet **801**, une fois assemblé par l'intermédiaire des billes de brasure **803**, demeure à distance du support **802** et en l'occurrence du fond de la cavité **820**. Comme exposé précédemment, cette absence de contact entre l'objet et le support contribue à augmenter la précision du positionnement du premier sur le deuxième.

Pour réaliser un tel assemblage, il faut mettre en oeuvre une forme de réalisation du procédé de l'invention dans laquelle une étape préalable consiste à réaliser dans le support la cavité **820** et dans laquelle l'étape de positionnement de l'objet **801** consiste :
- à positionner la partie inférieure de l'objet **801** dans ladite cavité **820** de manière à ce que les zones de mouillabilité **811** de l'objet **801** se trouvent à une altitude supérieure à l'altitude du centre de gravité de l'objet **801** et supérieure à l'altitude de la surface supérieure du support **802** ;
- à chauffer les billes de brasure **803** au-delà de la température de fusion du matériau de brasure, de manière à recouvrir par tension superficielle substantiellement chaque zone de mouillabilité **811** et **812**, les billes recouvrant les zones de mouillabilité **811** de l'objet **801 ;** l'objet s'aligne verticalement sous l'effet d'une part de la gravité et d'autre part des efforts de tension superficielle générés par les billes de brasure **803** en fusion sur les zones de mouillabilité **811** de l'objet **801**.

Le jeu existant entre le bord inférieur de l'objet **801** et le bord inférieur de la cavité **820** présente une hauteur qui dépend de plusieurs paramètres. Parmi ces paramètres, on peut citer en premier lieu la hauteur des zones de mouillabilité **811** sur l'objet **801**, la hauteur du centre de gravité de l'objet **801**, la quantité de matériau de brasure destiné à former les billes **803** et la profondeur de la cavité **820**.

Bien évidemment, ces différents paramètres sont déterminés en fonction du jeu ou de la distance souhaitée entre le bord inférieur de l'objet **801** et le fond de la cavité **820**. Par « bord inférieur », on désigne le bord situé à une altitude inférieure dans le cas où l'assemblage repose horizontalement sur le support **802**. En pratique, le jeu entre l'objet **801** et le support **802** est surtout déterminé de manière à ce que le faisceau laser **804** émis par l'émetteur laser VCSEL **801** se propage selon la direction d'une fibre optique **805** ménagée dans le support **802**.

Compte tenu de l'absence de contact entre l'objet et le support, le positionnement de l'objet **801** peut être réalisé avec une précision bien supérieure à celle des assemblages de l'art antérieur. De cette manière, on peut s'assurer que le faisceau laser **804** transmet le maximum de puissance à la fibre optique **805**. Pour obtenir ce mode de réalisation de l'assemblage objet de l'invention, il n'est pas nécessaire d'employer un revêtement sacrificiel, contrairement aux formes de réalisation précédemment décrites, au cours de la mise en oeuvre du procédé d'assemblage de l'objet **801** avec le support **802**.

Comme indiqué précédemment, il est possible de prévoir un angle différent de 90° entre les zones de mouillabilité de l'objet et celles du support. Ainsi, dans l'assemblage illustré par la figure 9, la direction principale de l'émetteur laser VCSEL **901** forme globalement un angle **921** de 75° avec le plan de la plateforme microélectronique **902**. Par cette construction, l'émetteur laser VCSEL **901** émet un faisceau laser **904** oblique en direction d'une fibre optique **905**. Un tel assemblage permet d'émettre au mieux un faisceau laser en direction de la fibre optique **905**, qui est polie de manière oblique pour limiter les réflexions parasites.

Pour réaliser un tel assemblage, il est préférable de former des billes **903** de dimensions différentes au sein d'un même couple de billes. De plus, il faut dimensionner et positionner les zones de mouillabilité de l'objet de manière asymétrique, comme le montre la figure 9. Mises à part ces spécificités, il faut mettre en oeuvre un procédé d'assemblage analogue à ceux décrits en relation avec les figures 4 ou 5, c'est-à-dire en employant un revêtement sacrificiel. La description de ces procédés d'assemblage n'est donc pas répétée ici.

Les figures 10a et 10b illustrent deux assemblages juxtaposés d'un émetteur laser VCSEL **1001** et d'un composant optique miniaturisé **1050**. Le composant optique miniaturisé **1050** est en fait une puce optique destinée à traiter le faisceau laser émis par l'émetteur laser **1001** avant son guidage dans la fibre optique **1005**. La fibre optique est logée dans une gorge à section en V **1006**, ménagée dans le support **1002**, ici une plateforme microélectronique, ladite gorge à section en V **1006** permettant de positionner de façon précise la fibre optique par rapport au référentiel que constitue la plate-forme **1002**. Les objets **1001** et **1050** sont assemblés avec la plateforme **1002** conformément à l'invention et en particulier selon un procédé analogue à celui décrit en relation avec les figures 5a à 5d.

Cependant, sur la figure 10a, on constate que les billes **1003** et **1053** destinées à être solidarisées sur les faces avant des objets **1001** et **1050** sont décalées dans le sens transversal à l'axe optique par rapport aux billes de brasure **1003** et **1053** destinées à être solidarisées sur les faces arrières des objets **1001** et **1050**. Un tel décalage permet d'assurer une certaine stabilité des objets lors de leur assemblage avec la plateforme **1002**, notamment dans le sens transversal.

Comme on peut le voir sur les figures 10a et 10b, des circuits électriques **1030** et **1031** sont reliés aux zones de mouillabilité et des billes de brasure **1003** de l'émetteur laser VCSEL **1001**. Ce dernier peut ainsi être alimenté en courant électrique par un générateur (non représenté). A l'inverse, la puce de traitement optique **1050**, qui est un composant passif, ne nécessite pas d'alimentation en courant électrique, si bien que la plateforme **1002** ne présente pas de circuit électrique connecté aux billes **1053** destinées à être solidarisées à l'objet **1050**.

La formation des galettes de matériau de brasure est réalisée de manière connue au moyen de techniques conventionnelles, parmi lesquelles on peut citer le dépôt d'une couche de métallisation d'accrochage, la photolithogravure, l'élimination de matière par attaque chimique, la croissance électrolytique etc. Toutes ces techniques étant connues pour former des galettes, donc des billes de brasure, leurs caractéristiques ne sont pas décrites dans le présent exposé.

La seule spécificité de la formation des galettes de brasure dans le procédé d'assemblagede l'invention consiste à déposer une couche de revêtement sacrificiel puis à y réaliser des orifices avant d'apporter le matériau de brasure sur le substrat, lequel peut être constitué d'une plaquette de matériau semi-conducteur. La réalisation de ce revêtement sacrificiel est aussi effectuée par des techniques conventionnelles, comme le dépôt de couches minces par évaporation ou par pulvérisation.

Par ailleurs, lorsque le substrat de départ employé est une plaquette de matériau semi-conducteur, que ce soit pour réaliser les billes de brasure sur l'objet ou sur le support, ce substrat peut comporter un ou plusieurs composants électroniques et/ou un ou plusieurs capteurs. Cela permet de réaliser un système complexe remplissant de multiples fonctions de manière relativement dense.

Un assemblage tel que ceux décrits précédemment peut être mis en oeuvre par exemple pour équiper un système d'émetteur-récepteur déployé dans les réseaux optiques utilisés pour le transfert de données dans le domaine des télécommunications.

Par ailleurs, bien que les exemples exposés en relation avec les figures portent principalement sur l'implantation d'un émetteur laser VCSEL, il est évident que l'invention ne se limite pas à ces composants et qu'elle peut être mise en oeuvre avec de nombreux autres objets et supports.

Ainsi, on peut implanter des puces MEMS ou des accéléromètres. Dans ce dernier cas, l'invention s'avère particulièrement avantageuse pour réaliser un capteur apte à mesurer les vibrations selon les trois dimensions de l'espace. Pour cela, il faut assembler deux accéléromètres sur un troisième, selon l'un des procédés objets de l'invention et selon les trois axes de mesure. De cette manière, l'invention permet de réaliser un accéléromètre tridimensionnel très précis.

D'autres réalisations sont possibles sans quitter le cadre de cette invention. Ainsi, on pourrait envisager un mode de réalisation hybride entre les modes de réalisation illustrés par les figures 4 et 5, dans lequel certaines billes seraient formées sur l'objet, tandis que les autres seraient formées sur le support. Ou encore, un mode où les billes seraient formées pour partie sur l'objet et pour le reste sur le support.

## Revendications

1. Assemblage d'un objet (401 ; 501 ; 601 ; 701 ; 801 ; 901 ; 1001) et d'un support (402 ; 502 ; 602 ; 702 ; 802 ; 902 ; 1002) par l'intermédiaire de billes de brasure (403 ; 503, 516 ; 603 ; 703, 716 ; 803 ; 903 ; 1003, 1053), dans lequel :
- au moins deux zones de mouillabilité (411, 412 ; 511, 512 ; 81 1, 812) sont réalisées respectivement sur ledit objet (401 ; 501 ; 601 ; 701 ; 801 ; 901 ; 1001) et sur ledit support (402 ; 502 ; 602 ; 702 ; 802 ; 902 ; 1002),
- chacune des billes de brasure (403 ; 503, 516 ; 603 ; 703, 716 ; 803 ; 903 ; 1003, 1053) assure un contact électrique et une fixation mécanique d'une part avec l'une desdites zones de mouillabilité (411 ; 511 ; 811) dudit objet (401 ; 501 ; 601 ; 701 ; 801 ; 901 ; 1001) et d'autre part avec l'une desdites zones de mouillabilité (412 ; 512 ; 812) dudit support (402 ; 502 ; 602 ; 702 ; 802 ; 902 ; 1002),
- la température de fusion des billes de brasure (403 ; 503, 516 ; 603 ; 703, 716 ; 803 ; 903 ; 1003, 1053) étant inférieure à la température de fusion de chacune des zones de mouillabilité (411, 412 ; 511, 512 ; 811, 812),
- l'objet (401 ; 501 ; 601 ; 701 ; 801 ; 901 ; 1001) et le support (402 ; 502 ; 602 ; 702 ; 802 ; 902 ; 1002) sont mutuellement distants
***caractérisé* en ce que** chaque zone de mouillabilité (411 ; 511 ; 811) dudit objet (401 ; 501 ; 601 ; 701 ; 801 ; 901 ; 1001) forme un angle (921) compris entre 70° et 110° avec chaque zone de mouillabilité (412 ; 512 ; 812) dudit support (402 ; 502 ; 602 ; 702 ; 802 ; 902 ; 1002).

2. Assemblage selon la revendication 1, ***caractérisé* en ce que** l'angle (921) formé entre chaque zone de mouillabilité (411 ; 511 ; 811) de l'objet (401 ; 501 ; 601 ; 701 ; 801 ; 901 ; 1001) et chaque zone de mouillabilité (412 ; 512 ; 812) du support (402 ; 502 ; 602 ; 702 ; 802 ; 902 ; 1002) est sensiblement égal à 90°.

3. Assemblage selon l'une des revendications 1 et 2, ***caractérisé* en ce que** la partie inférieure de l'objet (801) est reçue dans une cavité (820) réalisée dans le support (802), le bord inférieur de l'objet (801) étant distant du fond de la cavité (820).

4. Assemblage selon l'une des revendications 1 à 3, ***caractérisé* en ce que** billes de brasure (703, 716) présentent différentes dimensions.

5. Assemblage selon l'une des revendications 1 à 4, ***caractérisé* en ce que** le matériau constitutif des billes de brasure (403 ; 503, 516 ; 603 ; 703, 716 ; 803 ; 903 ; 1003, 1053) est constitué d'un élément pur ou d'un alliage d'éléments sélectionnés dans le groupe comprenant l'étain (Sn), le plomb (Pb), l'or (Au) et l'indium (In).

6. Assemblage selon l'une des revendications 1 à 5, ***caractérisé* en ce que** chaque zone de mouillabilité (411, 412 ; 511, 512 ; 811, 812) comporte un empilement de plusieurs couches dont les matériaux sont constitués d'éléments sélectionnés dans le groupe comprenant le titane (Ti), le nickel (Ni) et l'or (Au).

7. Assemblage selon l'une des revendications 1 à 6, ***caractérisé* en ce que** le support (402 ; 502 ; 602 ; 702 ; 802 ; 902 ; 1002) est une plate-forme microélectronique, et **en ce que** l'objet (401 ; 501 ; 601 ; 701 ; 801 ; 901 ; 1001) est un composant optique ou optoélectronique, tel qu'un émetteur laser à cavité verticale émettant par la surface (VCSEL) à cavité verticale.

8. Procédé d'assemblage d'un objet (401 ; 501 ; 601 ; 701 ; 801 ; 901 ; 1001) et d'un support (402 ; 502 ; 602 ; 702 ; 802 ; 902 ; 1002) au moyen d'un matériau de brasure, dans lequel :
- au moins deux zones de mouillabilité sont réalisées respectivement sur ledit objet (401 ; 501 ; 601 ; 701 ; 801 ; 901 ; 1001) et sur ledit support (402 ; 502 ; 602 ; 702 ; 802 ; 902 ; 1002),
- la température de fusion du matériau de brasure est inférieure à la température de fusion de chacune des zones de mouillabilité (411, 412 ; 511,512;811,812),
le procédé consistant :
- à former des billes de brasure (403 ; 503, 516 ; 603 ; 703, 716 ; 803 ; 903 ; 1003, 1053) sur le support (402 ; 502 ; 602 ; 702 ; 802 ; 902 ; 1002) ou sur l'objet (401 ; 501 ; 601 ; 701 ; 801 ; 901 ; 1001) au moyen d'une succession d'étapes consistant :
■ à réaliser, soit sur chaque zone de mouillabilité (411 ; 511 ; 811) de l'objet (401 ; 501 ; 601 ; 701 ; 801 ; 901 ; 1001), soit sur chaque zone de mouillabilité (412 ; 512 ; 812) du support (402 ; 502 ; 602 ; 702 ; 802 ; 902 ; 1002), une galette constituée dudit matériau de brasure ;
■ à chauffer lesdites galettes au-delà de la température de fusion dudit matériau de brasure mais en deçà de la température de fusion de chacune des zones de mouillabilité (411, 412 ; 511, 512 ; 811, 812), de manière à transformer par tension superficielle chacune des galettes en une bille de brasure (403 ; 503, 516 ; 603 ; 703, 716 ; 803 ; 903 ; 1003, 1053) ;
■ à refroidir l'assemblage obtenu jusqu'à une température inférieure à la température de fusion dudit matériau de brasure, de façon à figer lesdites billes de brasure (403 ; 503, 516 ; 603 ; 703, 716 ; 803 ; 903 ; 1003, 1053) ainsi formées ;
- à positionner l'objet (401 ; 501 ; 601 ; 701 ; 801 ; 901 ; 1001) par rapport au support (402 ; 502 ; 602 ; 702 ; 802 ; 902 ; 1002) de manière à placer chacune desdites billes de brasure (403 ; 503, 516 ; 603 ; 703, 716 ; 803 ; 903 ; 1003, 1053) sensiblement et partiellement en regard de la surface de chaque zone de mouillabilité (411 ; 511 ; 811) de l'objet (401 ; 501 ; 601 ; 701 ; 801 ; 901 ; 1001) d'une part et d'une surface correspondante de chaque zone de mouillabilité (412 ; 512 ; 812) du support (402 ; 502 ; 602 ; 702 ; 802 ; 902 ; 1002) d'autre part;
- à chauffer lesdites galettes au-delà de la température de fusion dudit matériau de brasure, de façon à former et à mouvoir les billes de brasure (403 ; 503, 516 ; 603 ; 703, 716 ; 803 ; 903 ; 1003, 1053) par tension superficielle, de manière à assurer une coopération entre chaque bille de brasure (403 ; 503, 516 ; 603 ; 703, 716 ; 803 ; 903 ; 1003, 1053) et l'une des zones de mouillabilité (411 ; 511 ; 811) de l'objet (401 ; 501 ; 601 ; 701 ; 801 ; 901 ; 1001) d'une part, et l'une des zones de mouillabilité (412 ; 512 ; 812) du support (402 ; 502 ; 602 ; 702 ; 802 ; 902 ; 1002) d'autre part ;
- à refroidir l'assemblage obtenu jusqu'à une température inférieure à la température de fusion dudit matériau de brasure, de façon à figer l'assemblage ainsi formé;
le procédé étant **caractérisé en ce que** chaque zone de mouillabilité (411 ; 511 ; 811) de l'objet (401 ; 501 ; 601 ; 701 ; 801 ; 901 ; 1001) forme un angle (921) compris entre 70° et 110° avec chaque zone de mouillabilité (412 ; 512 ; 812) du support (402 ; 502 ; 602 ; 702 ; 802 ; 902 ; 1002).

9. Procédé d'assemblage selon la revendication 8, ***caractérisé* en ce que** l'étape de formation des billes de brasure consiste :
- à déposer sur les zones de mouillabilité (411) de l'objet (401) un revêtement sacrificiel (413) peu mouillant vis-à-vis du matériau de brasure et présentant une température de fusion supérieure à celle du matériau de brasure, ledit revêtement sacrificiel (413) s'étendant de manière dissymétrique sur la surface principale de chaque zone de mouillabilité (411) de l'objet (401) ;
- à percer dans ledit revêtement sacrificiel (413) des orifices débouchant chacun au niveau de la surface principale d'une zone de mouillabilité (411) de l'objet (401) et vers la partie de la zone de mouillabilité (411) de l'objet (401) opposée au bord le plus proche de l'objet (401) ;
- à réaliser lesdites galettes par dépôt dudit matériau de brasure sur le revêtement sacrificiel y compris dans ledit orifice ;
- à chauffer les galettes au-delà de la température de fusion du matériau de brasure, de manière à les transformer par tension superficielle en billes de brasure (403) recouvrant totalement ou partiellement le revêtement sacrificiel (413) ; .
- à ôter ledit revêtement sacrificiel (413), chaque bille (403) étant alors reliée à une zone de mouillabilité (411) par un pied (414) issu du dépôt du matériau de brasure dans ledit orifice, ledit pied (414) étant positionné sur la partie de la zone de mouillabilité (411) opposée au bord le plus proche de l'objet (401) ;
- à découper le bord de l'objet (401) le plus proche de la zone de mouillabilité (411) de manière à réduire l'une des dimensions de l'objet (401) ;
- à chauffer lesdites billes de brasure (403) au-delà de leur température de fusion, de manière à recouvrir totalement chacune desdites zones de mouillabilité (411), la périphérie des billes (403) dépassant du bord de l'objet (401) issu de ladite découpe, les billes (403) recouvrant les zones de mouillabilité (412) du support (402) par l'effet de la tension superficielle.

10. Procédé d'assemblage selon la revendication 8, ***caractérisé* en ce que** l'étape de formation des billes de brasure (503) consiste :
- à déposer sur les zones de mouillabilité (512) du support un revêtement sacrificiel (513) peu mouillant vis-à-vis du matériau de brasure et présentant une température de fusion supérieure à celle du matériau de brasure, ledit revêtement sacrificiel (513) s'étendant de manière dissymétrique sur la surface principale de chacune des zones de mouillabilité (512) du support (502) ;
- à percer dans ledit revêtement sacrificiel (513) des orifices débouchant chacun au niveau de la surface principale d'une zone de mouillabilité (512, 517) du support (502) et de manière décalée vers le côté opposé à l'autre zone de mouillabilité (512) du support (502) ;
- à réaliser lesdites galettes par dépôt dudit matériau de brasure sur le revêtement sacrificiel y compris dans ledit orifice ;
- à chauffer les galettes au-delà de la température de fusion du matériau de brasure, de manière à les transformer par tension superficielle en billes de brasure (503, 516) recouvrant totalement ou partiellement le revêtement sacrificiel (513) ;
- à ôter ledit revêtement sacrificiel (513), chaque bille (503) étant alors reliée à une zone de mouillabilité (512) par un pied (514) issu du dépôt du matériau de brasure dans ledit orifice, ledit pied (514) étant positionné sur la zone de mouillabilité (512) du côté opposé à l'autre zone de mouillabilité (512) du support (502).

11. Procédé d'assemblage selon la revendication 10, ***caractérisé* en ce que** le support (502) présente, entre ses deux zones de mouillabilité (512), au moins une zone de mouillabilité supplémentaire (517) de dimensions inférieures à celles de chacune desdites deux zones de mouillabilité (512), ladite zone de mouillabilité supplémentaire (517) étant soumise à l'étape de formation de bille de brasure (503) selon la revendication 8, avec ou sans décalage de l'orifice afférent, et **en ce que** l'étape de positionnement de l'objet (501) consiste :
- à positionner l'objet (501) entre les deux grandes billes (503) en contact avec la petite bille (516) ;
- à chauffer lesdites billes de brasure (503, 516) au-delà de la température de fusion dudit matériau de brasure, de manière à recouvrir par tension superficielle substantiellement chaque zone de mouillabilité (511) de l'objet (512, 517) et du support (502).

12. Procédé d'assemblage selon la revendication 8, ***caractérisé* en ce qu'**il comprend en outre une étape consistant à réaliser dans le support une cavité (820) destinée à recevoir la partie inférieure dudit objet (801) et **en ce que** l'étape de positionnement de l'objet (801) consiste :
- à positionner la partie inférieure de l'objet (801) dans ladite cavité (820) de manière à ce que les zones de mouillabilité de l'objet (801) se trouvent à une altitude supérieure à l'altitude du centre de gravité de l'objet (801) et supérieure à l'altitude de la surface supérieure du support (802) ;
- à chauffer lesdites billes de brasure (803) au-delà de la température de fusion dudit matériau de brasure, de manière à recouvrir par tension superficielle substantiellement chaque zone de mouillabilité (811, 812), les billes recouvrant les zones de mouillabilité (811) de l'objet (801), lequel est ainsi susceptible de s'aligner verticalement sous l'effet d'une part de la gravité et d'autre part des efforts de tension superficielle générés par les billes de brasure (803) en fusion sur les zones de mouillabilité (811) de l'objet (801).

## Claims

1. Assembly of an object (401; 501; 601; 701; 801; 901; 1001) and a support (402; 502; 602; 702; 802; 902; 1002) by using solder bumps (403; 503, 516; 603; 703, 716; 803; 903; 1003, 1053) in which:
- at least two wettability areas (411, 412: 511, 512: 811, 812) are made respectively on said object (401: 501: 601: 701: 801: 901: 1001) and on said support (402: 502: 602: 702: 802: 902: 1002),
- each solder bump (403; 503, 516; 603; 703, 716; 803; 903; 1003, 1053) ensures electrical contact and mechanical fixing firstly to one of the wettability areas (411; 511; 811) of said object (401; 501; 601; 701; 801; 901; 1001) and secondly to one of said wettability areas (412; 512; 812) of said support (402; 502; 602; 702; 802; 902; 1002),
- the melting temperature of solder bumps (403; 503, 516; 603; 703, 716; 803; 903; 1003, 1053) being below the melting temperature of each wettability area (411,412;511,512;811,812),
- said object (401; 501; 601; 701; 801; 901; 1001) and support (402; 502; 602; 702; 802; 902; 1002) are mutually distant ;
***characterised* in that** each wettability area (411; 511; 811) of said object (401; 501; 601; 701; 801; 901; 1001) forms an angle (921) of 70° to 110° with respect to each wettability area (412; 512; 812) of said support (402; 502; 602; 702; 802; 902; 1002).

2. An assembly as claimed in claim 1, ***characterised* in that** the angle (921) formed between each wettability area (411; 511; 811) of the object (401; 501; 601; 701; 801; 901; 1001) and each wettability area (412; 512; 812) of the support (402; 502; 602; 702; 802; 902; 1002) substantially equals 90°.

3. An assembly as claimed in any of claims 1 and 2, ***characterised* in that** the lower part of object (801) is accommodated in a cavity (820) made in support (802) with the lower edge of object (801) being some distance away from the bottom of cavity (820).

4. An assembly as claimed in any of claims 1 to 3, ***characterised* in that** solder bumps (703, 716) have different dimensions.

5. An assembly as claimed in any of claims 1 to 4, ***characterised* in that** the material that constitutes solder bumps (403; 503, 516; 603; 703, 716; 803; 903; 1003, 1053) consists of a pure element or an alloy of elements selected from the group comprising tin (Sn), lead (Pb), gold (Au) and indium (In).

6. An assembly as claimed in any of claims 1 to 5, ***characterised* in that** each wettability area (411, 412; 511, 512; 811, 812) comprises a stack of several layers of materials consisting of elements selected from the group comprising titanium (Ti), nickel (Ni) and gold (Au).

7. An assembly as claimed in any of claims 1 to 6, ***characterised* in that** the support (402; 502; 602; 702; 802; 902; 1002) is a microelectronic platform and **in that** the object (401; 501; 601; 701; 801; 901; 1001) is an optical or optoelectronic component such as a Vertical Cavity Surface Emitting Laser (VCSEL).

8. Method of assembling an object (401; 501; 601; 701; 801; 901; 1001) and a support (402; 502; 602; 702; 802; 902; 1002) by using a solder material in which:
- at least two wettability areas (401, 501: 601, 701: 801, 901) are made respectively on said object (401; 501; 601; 701; 801; 901; 1001) and on said support (402; 502; 602; 702; 802; 902; 1002),
- the melting temperature of the solder material is lower than the melting temperature of each wettability area (411; 412, 511; 512; 811, 812),
the method consisting in :
- forming solder bumps (403; 503, 516; 603; 703, 716; 803; 903; 1003, 1053) on the support (402; 502; 602; 702; 802; 902; 1002) or on the object (401; 501; 601; 701; 801; 901; 1001) by means of a succession of steps involving;
• producing, on each wettability area (411; 511; 811) of the object (401; 501; 601; 701; 801; 901; 1001) or on each wettability area (412; 512; 812) of the support (402; 502; 602; 702; 802; 902; 1002), an underbump metallisation consisting of said solder material;
• heating said underbump metallisations to above the melting temperature of said solder material but below the melting temperature of each wettability area (411, 412; 511, 512; 811, 812), so as to turn, due to surface tension, each underbump metallisation into a solder bump (403; 503, 516; 603; 703, 716; 803; 903; 1003, 1053);
• cooling the assembly thus obtained back down to a temperature below the melting temperature of said solder material so as to solidify said solder bumps (403; 503, 516; 603; 703, 716; 803; 903; 1003, 1053) thus formed;
- positioning object (401; 501; 601; 701; 801; 901; 1001) relative to support (402; 502; 602; 702; 802; 902; 1002) so as to place each of said solder bumps (403; 503, 516; 603; 703, 716; 803; 903; 1003, 1053) substantially and partially opposite the surface of each wettability area (411; 511; 811) of the object (401; 501; 601; 701; 801; 901; 1001) on the one hand and a corresponding surface of each wettability area (412; 512; 812) of the support (402; 502; 602; 702; 802; 902; 1002) on the other hand;
- heating said underbump metallisations to above the melting temperature of said solder material so as to form and move solder bumps (403; 503, 516; 603; 703, 716; 803; 903; 1003, 1053) by surface tension so as to ensure cooperation between each solder bump (403; 503, 516; 603; 703, 716; 803; 903; 1003, 1053) and one of wettability areas (411; 511; 811) of object (401; 501; 601; 701; 801; 901; 1001) on the one hand and one of wettability areas (412; 512; 812) of support (402; 502; 602; 702; 802; 902; 1002) on the other hand.
- cooling the assembly thus obtained back down to a temperature below the melting temperature of said solder material so as to solidify the assembly thus formed;
the method being **characterized in that** each wettability area (411; 511; 811) of the object (401; 501; 601; 701; 801; 901; 1001) forms an angle (921) of 70° to 110° with each wettability area (412; 512; 812) of the support (402; 502; 602; 702; 802; 902; 1002).

9. A method of assembling as claimed in claim 8, ***characterised* in that** the step to form the solder bumps involves:
- depositing, on wettability areas (411) of support (401), a sacrificial coating (413) that is relatively non-wetting in relation to the solder material and having a melting temperature higher than that of the solder material, said sacrificial coating (413) extending asymmetrically over the main surface of each wettability area (411) of support (401);
- drilling in said sacrificial coating (413) holes each of which emerges on the main surface of a wettability area (411) of object (401) and towards that part of wettability area (411) of object (401) which is opposite the closest edge of object (401);
- producing said underbump metallisations by depositing solder material on the sacrificial coating, as well as in said hole;
- heating the underbump metallisations to above the melting temperature of the solder material so as to turn them, by surface tension, into solder bumps (403) which completely or partially cover sacrificial coating (413);
- removing said sacrificial coating (413), each bump (403) then being connected to a wettability area (411) via a stalk (414) originating from the solder material deposited in said hole, said stalk (414) being positioned on the part of wettability area (411) opposite the closest edge of object (401);
- cutting the edge of object (401) which is the closest to wettability area (411) so as to reduce one of the dimensions of object (401) ;
- heating said solder bumps (403) to above their melting temperature so as to completely cover each of said wettability areas (411), with the periphery of solder bumps (403) protruding beyond the edge of object (401) obtained by said cutting and bumps (403) covering wettability areas (412) of support (402) due to the effect of surface tension.

10. A method of assembling as claimed in claim 8, ***characterised* in that** the step to form solder bumps (503) involves:
- depositing, on wettability areas (512) of the support, a sacrificial coating (513) that is relatively non-wetting in relation to the solder material and having a melting temperature higher than that of the solder material, said sacrificial coating (513) extending asymmetrically over the main surface of each wettability area (512) of support (502);
- then drilling, in said sacrificial coating (513), holes which each emerge on the main surface of a wettability area (512, 517) of support (502) and are offset towards the side opposite the other wettability area (512) of support (502);
- producing said underbump metallisations by depositing solder material on the sacrificial coating, as well as in said hole;
- heating the underbump metallisations to above the melting temperature of the solder material so as to turn them, by surface tension, into solder bumps (503, 516) which completely or partially cover sacrificial coating (513);
- removing said sacrificial coating (513), each bump (503) then being connected to a wettability area (512) via a stalk (514) originating from the solder material deposited in said hole, said stalk (514) being positioned on wettability area (512) at the end opposite the other wettability area (512) of support (502).

11. A method of assembling as claimed in claim 10, ***characterised* in that** support (502) has, between its two wettability areas (512), at least one additional wettability area (517) having dimensions smaller than those of each of the said two wettability areas (512), said additional wettability area (517) being subjected to a step to form a solder bump (503) as claimed in claim 8, with or without offsetting of the associated hole and **in that** the step to position object (501) involves:
- positioning object (501) between two large bumps (503) which are in contact with small bump (516);
- heating said solder bumps (503, 516) to above the melting temperature of said solder material so as to substantially cover each wettability area (511) of object (512, 517) and of support (502).

12. A method of assembling as claimed in claim 8, ***characterised* in that** it also comprises a step that involves making, in the support, a cavity (820) intended to accommodate the lower part of said object (801) and the step of positioning object (801) involves:
- positioning the lower part of object (801) in said cavity (820) so that the wettability areas of object (801) are at a height above that of the centre of gravity of object (801) and above the height of the upper surface of support (802);
- heating said solder bumps (803) to above the melting temperature of said solder material so as to substantially cover, by surface tension, each wettability area (811, 812) with the bumps covering wettability areas (811) of object (801) which is thus capable of aligning itself vertically due to the effect of gravity, on the one hand, and the surface tension forces produced by solder bumps (803) melted on wettability areas (811) of object (801), on the other hand.

## Patentansprüche

1. Fügeverbindung eines Formstücks (401; 501; 601; 791; 801; 901; 1001) und eines Trägers (402; 502; 602; 702; 802; 902; 1002) mittels Lötkugeln (403; 503; 516; 603; 703; 716; 803; 903; 1003; 1053), wobei:
- mindestens zwei Benetzbarkeitsbereiche (411, 412; 511, 512; 811, 812) am Formstück (401; 501; 601; 701; 801; 901; 1001) bzw. am Träger (402; 502; 602; 702; 802; 902; 1002) ausgebildet sind,
- jede der Lötkugeln (403; 503; 516; 603; 703; 716; 803; 903; 1003; 1053) einen elektrischen Kontakt und eine mechanische Fixierung einerseits mit einem der Benetzbarkeitsbereiche (411; 511; 811) des Formstücks (401; 501; 601; 701; 801; 901; 1001) und andererseits mit einem der Benetzbarkeitsbereiche (412; 512; 812) des Trägers (402; 502; 602; 702; 802; 902; 1002) sicherstellt,
- die Schmelztemperatur der Lötkugeln (403; 503; 516; 603; 703; 716; 803; 903; 1003; 1053) niedriger ist als die Schmelztemperatur jedes der Benetzbarkeitsbereiche (411, 412; 511, 512; 811, 812),
- das Formstück (401; 501; 601; 701; 801; 901; 1001) und der Träger (402; 502; 602; 702; 802; 902; 1002) voneinander beabstandet sind,
**dadurch gekennzeichnet, dass** jeder Benetzbarkeitsbereich (411; 511; 811) des Formstücks (401; 501; 601; 701; 801; 901; 1001) einen Winkel (921) zwischen 70° und 110° mit jedem Benetzbarkeitsbereich (412; 512; 812) des Trägers (402; 502; 602; 702; 802; 902; 1002) bildet.

2. Fügeverbindung nach Anspruch 1, **dadurch gekennzeichnet, dass** der zwischen jedem Benetzbarkeitsbereich (411; 511; 811) des Formstücks (401; 501; 601; 701; 801; 901; 1001) und jedem Benetzbarkeitsbereich (412; 512; 812) des Trägers (402; 502; 602; 702; 802; 902; 1002) gebildete Winkel (921) im Wesentlichen gleich 90° ist.

3. Fügeverbindung nach einem der Ansprüche 1 und 2, **dadurch gekennzeichnet, dass** der untere Teil des Formstücks (801) in einem im Träger (802) hergestellten Hohlraum (820) aufgenommen ist, wobei der untere Rand des Formstücks (801) vom Boden des Hohlraums (820) beabstandet ist.

4. Fügeverbindung nach einem der Ansprüche 1 bis 3, **dadurch gekennzeichnet, dass** die Lötkugeln (703; 716) verschiedene Abmessungen aufweisen.

5. Fügeverbindung nach einem der Ansprüche 1 bis 4, **dadurch gekennzeichnet, dass** der Werkstoff, aus dem die Lötkugeln (403; 503; 516; 603; 703; 716; 803; 903; 1003; 1053) bestehen, aus einem reinen Element oder einer Legierung von Elementen besteht, die aus der Gruppe ausgewählt sind, die Zinn (Sn), Blei (Pb), Gold (Au) und Indium (In) umfasst.

6. Fügeverbindung nach einem der Ansprüche 1 bis 5, **dadurch gekennzeichnet, dass** jeder Benetzbarkeitsbereich (411, 412; 511, 512; 811, 812) eine Stapelanordnung mehrerer Schichten umfasst, deren Werkstoffe aus Elementen bestehen, die aus der Gruppe ausgewählt sind, die Titan (Ti), Nickel (Ni) und Gold (Au) umfasst.

7. Fügeverbindung nach einem der Ansprüche 1 bis 6, **dadurch gekennzeichnet, dass** der Träger (402; 502; 602; 702; 802; 902; 1002) eine mikroelektronische Plattform ist, und dass das Formstück (401; 501; 601; 701; 801; 901; 1001) ein optisches oder optoelektronisches Bauteil ist, wie etwa ein Laseremitter mit vertikalem Hohlraum, der durch die Oberfläche mit vertikalem Hohlraum emittiert (VCSEL).

8. Verfahren zur Fügeverbindung eines Formstücks (401; 501; 601; 701; 801; 901; 1001) und eines Trägers (402; 502; 602; 702; 802; 902; 1002) mittels eines Lötstoffs, wobei:
- mindestens zwei Benetzbarkeitsbereiche am Formstück (401; 501; 601; 701; 801; 901; 1001) bzw. am Träger (402; 502; 602; 702; 802; 902; 1002) ausgebildet werden,
- die Schmelztemperatur des Lötstoffs niedriger ist als die Schmelztemperatur jedes der Benetzbarkeitsbereiche (411, 412; 511, 512; 811, 812),
wobei das Verfahren darin besteht:
- Lötkugeln (403; 503; 516; 603; 703; 716; 803; 903; 1003; 1053) am Träger (402; 502; 602; 702; 802; 902; 1002) oder am Formstück (401; 501; 601; 701; 801; 901; 1001) mittels einer Abfolge von Schritten zu bilden, die darin bestehen:
■ entweder an jedem Benetzbarkeitsbereich (411; 511; 811) des Formstücks (401; 501; 601; 701; 801; 901; 1001) oder an jedem Benetzbarkeitsbereich (412; 512; 812) des Trägers (402; 502; 602; 702; 802; 902; 1002) ein aus dem Lötstoff bestehendes Plättchen herzustellen;
■ die Plättchen über die Schmelztemperatur des Lötstoffs aber unter die Schmelztemperatur jedes der Benetzbarkeitsbereiche (411, 412; 511, 512; 811, 812) zu erwärmen, um durch Oberflächenspannung jedes der Plättchen in eine Lötkugel (403; 503; 51 G; 603; 703; 716; 803; 903; 1003; 1053) zu verwandeln;
■ die erhaltene Fügeverbindung auf eine Temperatur unter der Schmelztemperatur des Lötstoffs abzukühlen, um die so gebildeten Lötkugeln (403; 503; 516; 603; 703; 716; 803; 903; 1003; 1053) erstarren zu lassen;
- das Formstück (401; 501; 601; 701; 801; 901; 1001) in Bezug auf den Träger (402; 502; 602; 702; 802; 902; 1002) zu positionieren, um jede der Lötkugeln (403; 503; 516; 603; 703; 716; 803; 903; 1003; 1053) im Wesentlichen teilweise gegenüber der Oberfläche jedes Benetzbarkeitsbereichs (411; 511; 811) des Formstücks (401; 501; 601; 701; 801; 901; 1001) einerseits und einer entsprechenden Oberfläche jedes Benetzbarkeitsbereichs (412; 512; 812) des Trägers (402; 502; 602; 702; 802; 902; 1002) andererseits anzuordnen,
- die Plättchen über die Schmelztemperatur des Lötstoffs zu erwärmen, um durch Oberflächenspannung die Lötkugeln (403; 503; 516; 603; 703; 716; 803; 903; 1003; 1053) zu bilden und zu bewegen, um ein Zusammenwirken zwischen jeder Lötkugel (403; 503; 516; 603; 703; 716; 803; 903; 1003; 1053) und einem der Benetzbarkeitsbereiche (411; 511; 811) des Formstücks (401; 501; 601; 701; 801; 901; 1001) einerseits und einem der Benetzbarkeitsbereiche (412; 512; 812) des Trägers (402; 502; 602; 702; 802; 902; 1002) andererseits sicherzustellen;
- die erhaltene Fügeverbindung auf eine Temperatur unter der Schmelztemperatur des Lötstoffs abzukühlen, um die so hergestellte Fügeverbindung erstarren zu lassen;
wobei das Verfahren **dadurch gekennzeichnet ist, dass** jeder Benetzbarkeitsbereich (411; 511; 811) des Formstücks (401; 501; 601; 701; 801; 901; 1001) einen Winkel (921) zwischen 70° und 110° mit jedem Benetzbarkeitsbereich (412; 512; 812) des Trägers (402; 502; 602; 702; 802; 902; 1002) bildet.

9. Verfahren zur Fügeverbindung nach Anspruch 8, **dadurch gekennzeichnet, dass** der Schritt des Bildens der Lötkugeln darin besteht:
- auf den Benetzbarkeitsbereichen (411) des Formstücks (401) eine Opferschicht (413) abzuscheiden, die gegenüber dem Lötstoff wenig benetzend ist und eine Schmelztemperatur aufweist, die höher ist als diejenige des Lötstoffs, wobei sich die Opferschicht (413) auf der Hauptoberfläche jedes Benetzbarkeitsbereichs (411) des Formstücks (401) asymmetrisch erstreckt;
- in jede Opferschicht (413) Öffnungen zu bohren, die jeweils im Bereich der Hauptoberfläche eines Benetzbarkeitsbereichs (411) des Formstücks (401) und zu dem Teil des Benetzbarkeitsbereichs (411) des Formstücks (401) hin münden, der dem nächsten Rand des Formstücks (401) entgegengesetzt ist;
- die Plättchen durch Abscheiden des Lötstoffs auf der Opferschicht einschließlich in der Öffnung zu bilden;
- die Plättchen über die Schmelztemperatur des Lötstoffs zu erwärmen, um sie durch Oberflächenspannung in Lötkugeln (403) umzuwandeln, die die Opferschicht (413) ganz oder teilweise bedecken;
- die Opferschicht (413) zu entfernen, wobei dann jede Kugel (403) durch ein Füßchen (414), das aus der Abscheidung des Lötstoffs in der Öffnung entstanden ist, mit einem Benetzbarkeitsbereich (411) verbunden ist, wobei das Füßchen (414) auf dem Teil des Benetzbarkeitsbereichs (411) positioniert ist, der dem naheliegendsten Rand des Formstücks (401) entgegengesetzt ist;
- den Rand des Formstücks (401), der dem Benetzbarkeitsbereich (411) am naheliegendsten ist, abzuschneiden, um eine der Abmessungen des Formstücks (401) zu reduzieren;
- die Lötkugeln (403) über ihre Schmelztemperatur zu erwärmen, um jeden der Benetzbarkeitsbereiche (411) vollständig zu bedecken, wobei der Umfang der Kugeln (403) über den durch das Abschneiden entstandenen Rand des Formstücks (401) übersteht, wobei die Kugeln (403) die Benetzbarkeitsbereiche (412) des Trägers (402) durch die Wirkung der Oberflächenspannung bedecken.

10. Verfahren zur Fügeverbindung nach Anspruch 8, **dadurch gekennzeichnet, dass** der Schritt des Bildens der Lötkugeln (503) darin besteht:
- auf den Benetzbarkeitsbereichen (512) des Trägers eine Opferschicht (513) abzuscheiden, die gegenüber dem Lötstoff wenig benetzend ist und eine Schmelztemperatur aufweist, die höher ist als diejenige des Lötstoffs, wobei sich die Opferschicht (513) auf der Hauptoberfläche jedes der Benetzbarkeitsbereiche (512) des Trägers (502) asymmetrisch erstreckt;
- in die Opferschicht (513) Öffnungen zu bohren, die jeweils im Bereich der Hauptoberfläche eines Benetzbarkeitsbereichs (512, 517) des Trägers (502) und auf versetzte Weise zu der Seite hin münden, die dem anderen Benetzbarkeitsbereich (512) des Trägers (502) entgegengesetzt ist;
- die Plättchen durch Abscheiden des Lötstoffs auf der Opferschicht einschließlich in der Öffnung zu bilden;
- die Plättchen über die Schmelztemperatur des Lötstoffs zu erwärmen, um sie durch Oberflächenspannung in Lötkugeln (503, 516) umzuwandeln, die die Opferschicht (513) ganz oder teilweise bedecken;
- die Opferschicht (513) zu entfernen, wobei dann jede Kugel (503) durch ein Füßchen (514), das aus der Abscheidung des Lötstoffs in der Öffnung entstanden ist, mit einem Benetzbarkeitsbereich (512) verbunden ist, wobei das Füßchen (514) auf der Seite des Benetzbarkeitsbereichs (512) positioniert ist, die dem anderen Benetzbarkeitsbereich (512) des Trägers (502) entgegengesetzt ist.

11. Verfahren zur Fügeverbindung nach Anspruch 10, **dadurch gekennzeichnet, dass** der Träger (502) zwischen seinen beiden Benetzbarkeitsbereichen (512) mindestens einen zusätzlichen Benetzbarkeitsbereich (517) mit Abmessungen aufweist, die kleiner sind als diejenigen jeder der beiden Benetzbarkeitsbereiche (512), wobei der zusätzliche Benetzbarkeitsbereich (517) einem Schritt zur Bildung von Lötkugeln (503) nach Anspruch 8 mit oder ohne Versatz von der dazugehörigen Öffnung unterzogen wird, und dass der Schritt zur Positionierung des Formstücks (501) darin besteht:
- das Formstück (501) zwischen zwei großen Kugeln (503) in Kontakt mit der kleinen Kugel (516) zu positionieren;
- die Lötkugeln (503, 516) über die Schmelztemperatur des Lötstoffs zu erwärmen, um durch Oberflächenspannung im Wesentlichen jeden Benetzbarkeitsbereich (511) des Formstücks (512, 517) und des Trägers (502) zu bedecken.

12. Verfahren zur Fügeverbindung nach Anspruch 8, **dadurch gekennzeichnet, dass** es darüber hinaus einen Schritt umfasst, der darin besteht, im Träger einen Hohlraum (820) herzustellen, der dazu bestimmt ist, den unteren Teil des Formstücks (801) aufzunehmen, und dass der Schritt zur Positionierung des Formstücks (801) darin besteht:
- den unteren Teil des Formstücks (801) im Hohlraum (820) so zu positionieren, dass sich die Benetzbarkeitsbereiche des Formstücks (801) auf einer Höhenlage befinden, die höher als die Höhenlage des Schwerpunkts des Formstücks (801) und höher als die Höhenlage der Oberfläche des Trägers (802) ist;
- die Lötkugeln (803) über die Schmelztemperatur des Lötstoffs zu erwärmen, um durch Oberflächenspannung im Wesentlichen jeden Benetzbarkeitsbereich (811, 812) zu bedecken, wobei die Kugeln die Benetzbarkeitsbereiche (811) des Formstücks (801) bedecken, das somit in der Lage ist, sich unter der Wirkung der Schwerkraft einerseits und der Oberflächenspannungskräfte anderseits, die durch die auf den Benetzbarkeitsbereichen (811) des Formstücks (801) schmelzenden Lötkugeln (803) entstehen, vertikal auszurichten.
